# FASCICULE DE BREVET EUROPEEN

(11) **EP 2 272 929 B1**
(45) Date de publication et mention de la délivrance du brevet: **09.08.2017**
(21) Numéro de dépôt: 10290372.1
(22) Date de dépôt: 06.07.2010
(51) Int. Cl.: C09J 5/02, C08J 3/28, G03F 7/085, C09J 181/02

(54) **Procédé d'amélioration de l'adhésion d'un matériau réticulable par UV sur un substrat**
Verfahren zum Verbessern der Haftfestigkeit eines Materials mit UV vernetzbar auf einem Substrat
Process for improving the adhesion of a material crosslinkable by UV on a substrat

(30) Priorité: 09.07.2009 FR 0903393
(43) Date de publication de la demande: 12.01.2011
(73) Titulaire: Commissariat à l'Énergie Atomique et aux Énergies Alternatives, 75015 Paris (FR)
(72) Inventeur: Heitzmann, Marie, 38650 Sinard (FR); Benwadih, Mohammed, 94500 Champigny/Marne (FR)
(74) Mandataire: Gevers & Orès

(56) Documents cités:
- EP-A2- 2 022 816
- US-A1- 2004 072 933
- US-A1- 2007 246 441

## Description

L'invention concerne un procédé d'amélioration de l'adhésion d'une couche en un matériau réticulable par insolation par des rayons UV sur un substrat ainsi qu'un procédé de fabrication d'un transistor comprenant au moins une étape de mise en oeuvre d'un tel procédé.

Dans de nombreux domaines, il est nécessaire de relier entre elles une couche en un matériau polymère, à un substrat en un autre matériau polymérique ou métallique ou comprenant des zones métalliques ou encore semi-conducteurs.

Un matériau polymère est un matériau susceptible de polymériser, et est constitué de l'enchaînement répété d'un même motif, le monomère, les monomères étant reliés les uns aux autres par des liaisons covalentes.

Pour obtenir un film en un matériau polymère résistant soit à des sollicitations mécaniques, soit à des sollicitations chimiques, soit les deux, on utilise un procédé de réticulation d'un tel matériau polymère. La réticulation peut se produire, pour certains matériaux, par insolation par des rayons UV.

Dans tous les cas, lors de la réticulation, le matériau polymère passe de l'état viscoélastique à l'état solide, rigide, élastique et infusible.

Par ailleurs, l'adhésion d'un matériau sur la surface d'un autre matériau peut être définie comme un ensemble de phénomènes physiques et/ou chimiques qui prennent naissance lorsque deux surfaces sont mises en contact.

L'adhésion est liée à l'adhésivité c'est-à-dire, à l'aptitude à créer des forces d'interactions entre les deux surfaces, à l'état de surface, c'est-à-dire la surface spécifique, la porosité, les sites actifs, la pollution, des deux surfaces à faire adhérer ensemble, et de la mouillabilité des ces deux surfaces, c'est-à-dire de leur aptitude à créer un contact entre elles.

Il s'agit plus particulièrement de forces d'adhésion, c'est-à-dire des forces de cohésion des matériaux, par exemple par création de liaisons interatomiques.

Ces liaisons interatomiques peuvent être intramoléculaires, comme dans le cas des liaisons chimiques covalentes ou intermoléculaires, comme dans le cas des liaisons physiques faibles.

Le problème de l'amélioration de l'adhésion d'une couche en un matériau polymère sur la surface d'un substrat en un matériau différent se pose tout particulièrement lors de la fabrication d'un transistor.

En effet, un transistor est généralement composé d'un substrat en un matériau semi-conducteur organique, par exemple un pentacène modifié, par exemple du triisopropylsilyl pentacène (TIPS-pentacène), comme décrit par Park et al. dans "Solution-Processed TIPS-Pentacene Organic Thin-Film-Transistor Circuits, IEEE Electron Device Letters, Vol 28., n°10, octobre 2007", ou du pérylène, ou en un matériau semi-conducteur inorganique tel que le silicium, le germanium, ou encore l'arseniure de gallium.

Sur ce substrat, sont ensuite déposées des électrodes source et drain ainsi qu'une grille qui sont généralement en métal, plus particulièrement en aluminium, en or, ou encore en cuivre ou en argent et forment des zones métalliques sur la surface du substrat.

Ces zones métalliques sont déposées selon le motif voulu, sur la surface du substrat, en général par un procédé de photolithographie.

Dans un tel procédé, une couche d'un matériau réticulable par insolation par des rayons UV, mais non polymérisé, est déposée sur la surface voulue du substrat.

Un masque comprenant des ouvertures avec le motif voulu est déposé sur cette surface et l'ensemble est insolé par des rayons UV.

Les zones insolées du matériau polymère réticulable par insolation par des rayons UV sont réticulées. Dans les autres zones, le matériau reste à l'état non polymérisé et non réticulé.

Les zones non polymérisées et non réticulées sont alors éliminées à l'aide d'un solvant et le métal est déposé dans les zones dénudées de la surface du substrat.

Mais, dans un tel procédé, après l'insolation par des rayons UV, et lors de l'élimination des zones voulues de matériau polymère demeurant non réticulés, les zones de matériau polymère réticulé se décollent de la surface du substrat en raison de son manque d'adhérence, ce qui fait que le solvant attaque ce matériau en le soulevant.

Concrètement, le solvant s'immisce entre le substrat et la couche de matériau polymère réticulable par les rayons UV, ce qui entraîne un dépôt de métal non-conforme au motif voulu.

Il faut également, lors de la fabrication d'un transistor, déposer un matériau isolant sur la surface de matériau semi-conducteur comprenant éventuellement déjà des zones métalliques.

Le même procédé de photolithographie que précédemment est répété et les mêmes problèmes de manque d'adhérence du matériau polymère réticulable par insolation par des rayons UV sur la surface du métal et du matériau semi-conducteur se reproduit.

L'invention vise à résoudre le problème de manque d'adhérence d'un film en un matériau polymère réticulable par les rayons UV sur un substrat.

A cet effet, l'invention propose un procédé d'amélioration de l'adhésion d'une couche en un matériau M sur la surface d'un substrat S caractérisé en ce que le matériau M est un matériau réticulable par insolation par des rayons UV, et en ce qu'il comprend les étapes suivantes :
a) le dépôt sur au moins une surface du substrat S d'une composition polymérisable P, non polymérisée, comprenant au moins une molécule F comprenant un premier groupe réactif F1 apte à réagir, par insolation par des rayons UV avec un groupe réactif M1 de la surface du matériau M, et un second groupe réactif F2 apte à former des liaisons avec le(s) matériau(x) constituant(s) la surface du substrat S,
b) le dépôt, sur la couche de la composition P, non polymérisée obtenue à l'étape a) d'une couche en un matériau M, non réticulé, et
c) l'insolation par des rayons UV de la structure à trois couches obtenue à l'étape b).

Préférablement, la surface du substrat S comprend au moins une zone en un (des) matériau(x) choisi(s) parmi du polyéthylène téréphtalate (PET), du polyéthylène naphtalate (PEN), un métal, un matériau semi-conducteur minéral ou organique, et les mélanges de ceux-ci.

Dans un premier mode de mise en oeuvre du procédé de l'invention, la surface du substrat S comprend des zones en un métal choisi parmi Al, Au, Cu, Ag et des mélanges de ceux-ci.

Dans un second mode de mise en oeuvre du procédé de l'invention, la surface du substrat S comprend des zones en aluminium et le groupe réactif F2 de la molécule F est un groupement acide phosphonique.

Dans un troisième mode de mise en oeuvre du procédé de l'invention, la surface du substrat S comprend des zones en or et le groupe réactif F2 de la molécule F est un groupement thiol.

Le matériau M est choisi dans le groupe des matériaux à base d'acrylate, tel que le poly(éthylène glycol) diacrylate (PEGDA), d'uréthane acrylate, tel que la série des polyuréthanes acrylates hyperramifiés à fonctions hydroxy (WHPUD) commercialisés sous la marque Boltorn® H20 décrits par Anila Asif et al. dans "Photopolymerization of waterborne polyurethane acrylate dispersions based on hyperbranched aliphatic polyester and properties of the cured films", Colloid Polym Sci (2005) 283 : 721-730, de styrène, tel que le polystyrène à polymérisation initiée par le tetraphényl cyclopentadiène triphényl bismuthonium qui est décrit par Kaur et al. dans "Photopolymerisation of styrene initiated by triphenyl bismuthonium ylide", Macromol. Rapid Commun. 21, 291-295 (2000), et/ou de divinyl éther tel que les poly(vinyl cynnamates).

Le groupe réactif F1 de la molécule F est choisi parmi un groupement sylilé et un groupement à conjugaison pi.

La molécule F est choisie parmi le triméthylsilylpropanethiol et le triméthoxysylilpropanethiol.

L'invention propose aussi un procédé de fabrication d'un transistor caractérisé en ce qu'il comprend au moins une étape de mise en oeuvre du procédé d'amélioration de l'adhésion d'une couche en un matériau M, réticulable par insolation par des rayons UV, sur un substrat.

L'invention sera mieux comprise, et d'autres avantages et caractéristiques de celle-ci apparaîtront plus clairement à la lecture de la description explicative qui suit.

D'une manière générale, l'invention concerne un procédé d'amélioration de l'adhésion d'une couche en un matériau réticulable par insolation par des rayons UV sur la surface d'un substrat S, qui peut être en tout matériau, mais qui est en un matériau différent du matériau M.

L'invention propose, dans ce but, de déposer, entre la couche de matériau M et la surface du substrat S, une composition polymérisable, non polymérisée, comprenant au moins une molécule comprenant un premier groupe réactif F1 apte à réagir par insolation par des rayons UV, avec un groupe réactif M1 du matériau M et un second groupe réactif F2 apte à former une liaison avec le(s) matériau(x) constituant(s) la surface du substrat S, puis à polymériser l'ensemble, pour provoquer la réticulation du matériau M et la réaction des groupes réactif F1 avec les groupes réactif F1 de la molécule F avec les groupes réactif M1 du matériau M.

Ainsi, la couche de composition polymérisable P est parfaitement liée à la couche de matériau M lors de l'insolation par des rayons UV.

La molécule F comprend également un groupe réactif F2 apte à former une liaison avec le(s) matériau(x) constituant(s) la surface du substrat S.

En effet, comme on l'a vu, en particulier dans le cas d'un transistor, la surface du substrat S peut être soit une surface constituée entièrement d'un même matériau, soit comprendre des zones en un métal et/ou en un matériau isolant tel que SiO₂.

Ces liaisons peuvent être des liaisons intramoléculaires entre le(s) matériau(x) constituant(s) la surface du substrat S et le groupement F2.

Dans un mode de réalisation préféré, la surface du substrat S est en un matériau choisi parmi le polyéthylène téréphtalate (PET), le polyéthylène naphtalate (PEN), un métal, plus particulièrement l'or, l'aluminium, le cuivre et l'argent, un matériau semi-conducteur inorganique tels que le silicium, le germanium, l'arseniure de gallium, un matériau semi-conducteur organique tel qu'un matériau à base de pentacène modifié, par exemple le TIPS-pentacène, du pérylène ou un des ses dérivés, un matériau à base de diimide tel que le naphtalènetétracarboxylique diimide ou en un matériau isolant tel que de la silice.

En effet, ces matériaux sont utilisés pour la fabrication de transistors.

La surface du substrat S peut également comprendre des zones en un ou plus de ces matériaux, c'est-à-dire par exemple, en polyéthylène téréphtalate (PET) comprenant des zones en métal, ou encore un matériau semi-conducteur, minéral ou organique comprenant des zones métalliques.

Dans un mode de réalisation tout particulièrement préféré, le métal est l'aluminium ou l'or.

Lorsque le métal est l'aluminium, de préférence, le groupe réactif F2 est un groupement acide phosphonique.

Mais dans encore un autre mode de réalisation préféré du procédé de l'invention, le métal est de l'or.

Dans ce cas, de préférence, le groupe réactif F2 de la molécule M est un groupement thiol.

Quant au matériau M, il peut s'agir d'un matériau comprenant des groupements à base de diacrylate, de diuréthane acrylate, de distyrène ou encore de divinyl éther tel que par exemple un poly(vinyl cynnamate).

Ce matériau est de préférence un matériau diélectrique car c'est en général un tel matériau qui est utilisé pour les transistors.

Le groupe réactif F2 de la molécule F a pour fonction de réagir avec le matériau réticulable M lors de son insolation par des rayons UV.

Ce deuxième groupe réactif F2 peut être un groupement sylilé, un groupement à conjugaison pi, tel qu'un groupement alcène ou cétone.

Un exemple particulièrement préféré d'une molécule F est une molécule comprenant un groupement thiol et un groupement sylilé, telles que le triméthylsilylpropanethiol et le triméthoxysylilpropanethiol.

Ainsi, le procédé d'amélioration de l'adhésion d'une couche en un matériau M sur un substrat S est particulièrement avantageusement utilisé dans un procédé de fabrication d'un transistor.

Dès lors, l'invention propose également un procédé de fabrication d'un transistor qui comprend au moins une étape de mise en oeuvre du procédé d'amélioration de l'adhésion d'un matériau polymère réticulable par insolation UV, sur un substrat.

Afin de mieux faire comprendre l'invention, on va maintenant en décrire, à titre purement illustratif et non limitatif, un exemple de mise en oeuvre.

### EXEMPLE 1 :

Le substrat utilisé ici est un substrat en plastique, plus précisément en polyéthylène naphtalate sur lequel est déposé une grille en or par évaporation à travers un masque.

L'épaisseur de la grille obtenue est de 90 nm.

Ainsi, le substrat utilisé ici a une surface comprenant des zones en polyéthylène naphtalate et des zones en or.

Sur la surface de ce substrat, une composition polymérisable selon l'invention, non polymérisée, ici du triméthoxysilylpropanethiol, est déposée sur la grille.

Cette composition adhère immédiatement à la grille par création de liaisons covalentes S-Au entre l'or de la grille et la composition polymérisable.

Puis un polymère réticulable par UV est déposé à la tournette sur toute la surface du substrat.

L'épaisseur de la couche de polymère déposée est de 850 nm.

Le polymère réticulable par UV est dans cet exemple, le poly(vinylcynnamate).

Ensuite, la surface du substrat est insolée au travers d'un masque avec une lampe UV placée à 10 cm de la surface du substrat recouverte du polymère d'acrylate.

La durée de l'insolation est de 45 minutes. Elle est effectuée à une longueur d'onde de 365 nm à une puissance de 14 mW/cm².

Lors de cette insolation, le polymère et la composition polymérisable triméthoxysilylpropanethiol réticulent, entraînant l'adhésion du polymère sur la surface du substrat.

On procède ensuite à un recuit à 100 °C pendant 20 minutes pour séchage.

Les zones non insolées de polymère et de triméthoxysilylpropanethiol sont éliminées par un révélateur, le tetrahydrofurane (THF), pour faire apparaître les motifs.

On utilise le substrat ainsi obtenu pour la fabrication des électrodes de source et de drain.

Ceci se fait par dépôt d'une couche d'or d'une épaisseur de 60 nm déposée par évaporation à travers un masque.

Puis le matériau semi-conducteur, ici du pentacène, est déposé à la tournette pour obtenir un transistor.

Le transistor obtenu présente d'excellentes propriétés, en particulier en termes d'adhésion.

## Revendications

1. Procédé d'amélioration de l'adhésion d'une couche en un matériau M sur la surface d'un substrat S **caractérisé en ce que** :
- le matériau M est un matériau réticulable par insolation par des rayons UV,
et **en ce qu'**il comprend les étapes suivantes :
a) le dépôt sur au moins une surface du substrat S d'une composition polymérisable P, non polymérisée, comprenant au moins une molécule F comprenant un premier groupe réactif F1 apte à réagir, par insolation par des rayons UV avec un groupe réactif M1 de la surface du matériau M, et un second groupe réactif F2 apte à former des liaisons avec le(s) matériau(x) constituant(s) la surface du substrat S,
b) le dépôt, sur la couche de la composition P, non polymérisée obtenue à l'étape a) d'une couche en un matériau M, non réticulé, et
c) l'insolation par des rayons UV de la structure à trois couches obtenue à l'étape b).

2. Procédé selon la revendication 1 **caractérisé en ce que** la surface du substrat S comprend au moins une zone en un (des) matériau(x) choisi(s) parmi du polyéthylène téréphtalate (PET), du polyéthylène naphtalate (PEN), un métal, un matériau semi-conducteur minéral ou organique, et les mélanges de ceux-ci.

3. Procédé selon la revendication 1 ou 2 **caractérisé en ce que** la surface du substrat S comprend des zones en un métal choisi parmi Al, Au, Cu, Ag et des mélanges de ceux-ci.

4. Procédé selon l'une quelconque des revendications précédentes **caractérisé en ce que** la surface du substrat S comprend des zones en aluminium et **en ce que** le groupe réactif F2 de la molécule F est un groupement acide phosphonique.

5. Procédé selon l'une quelconque des revendications 1 à 3 **caractérisé en ce que** la surface du substrat S comprend des zones en or et **en ce que** le groupe réactif F2 de la molécule F est un groupement thiol.

6. Procédé selon l'une quelconque des revendications précédentes **caractérisé en ce que** le matériau M est choisi dans le groupe des matériaux à base d'acrylate, d'uréthane acrylate, de styrène et/ou de divinyl éther.

7. Procédé selon l'une quelconque des revendications précédentes **caractérisé en ce que** le groupe réactif F1 de la molécule F est choisi parmi un groupement sylilé et un groupement à conjugaison pi.

8. Procédé selon les revendications 5 et 7 **caractérisé en ce que** la molécule F est choisie parmi le triméthylsilylpropanethiol et le triméthoxysylilpropanethiol.

9. Procédé de fabrication d'un transistor **caractérisé en ce qu'**il comprend au moins une étape de mise en oeuvre du procédé d'amélioration de l'adhésion d'une couche en un matériau M réticulable par insolation par des rayons UV sur un substrat selon l'une quelconque des revendications 1 à 8.

## Patentansprüche

1. Verfahren zur Verbesserung der Haftung einer Schicht aus einem Material M auf der Oberfläche eines Substrats S, **dadurch gekennzeichnet, dass**:
- das Material M ein durch Bestrahlung mit UV-Strahlen vernetzbares Material ist,
und dadurch, dass es folgende Schritte umfasst:
a) Auftragen auf zumindest eine Oberfläche des Substrats S einer polymerisierbaren Zusammensetzung P, nicht polymerisiert, die zumindest ein Molekül F umfasst, das eine erste reaktive Gruppe F1 umfasst, dazu fähig durch Bestrahlung mit UV-Strahlen mit einer reaktiven Gruppe M1 der Oberfläche des Materials M zu reagieren, und eine zweite reaktive Gruppe F2, dazu fähig, Verbindungen mit dem (den) Materialbestandteil(en) der Oberfläche des Substrats S zu bilden,
b) Auftragen auf die Schicht der Zusammensetzung P, nicht polymerisiert, erhalten bei Schritt a), einer Schicht aus einem Material M, nicht vernetzt, und
c) Bestrahlung der in Schritt b) erhaltenen Struktur aus drei Schichten mit UV-Strahlen.

2. Verfahren nach Anspruch 1, **dadurch gekennzeichnet, dass** die Oberfläche des Substrats S zumindest einen Bereich umfasst, bestehend aus einem (mehreren) Material(ien) ausgewählt unter Polyethylenterephthalat (PET), Polyethylennaphthalat (PEN), einem Metall, einem mineralischen oder organischen Halbleitermaterial und den Mischungen daraus.

3. Verfahren nach Anspruch 1 oder 2, **dadurch gekennzeichnet, dass** die Oberfläche des Substrats S zumindest Bereiche aus einem Metall umfasst, ausgewählt unter Al, Au, Cu, Ag und Mischungen daraus.

4. Verfahren nach einem der vorhergehenden Ansprüche, **dadurch gekennzeichnet, dass** die Oberfläche des Substrats S Bereiche aus Aluminium umfasst und dadurch, dass die reaktive Gruppe F2 des Moleküls F eine Phosphorsäuregruppe ist.

5. Verfahren nach einem der Ansprüche 1 bis 3, **dadurch gekennzeichnet, dass** die Oberfläche des Substrats S Bereiche aus Gold umfasst und dadurch, dass die reaktive Gruppe F2 des Moleküls F eine Thiolgruppe ist.

6. Verfahren nach einem der vorhergehenden Ansprüche, **dadurch gekennzeichnet, dass** das Material M aus der Gruppe von Materialien auf der Basis von Acrylat, Urethanacrylat, Styren und/oder Divinylether ausgewählt ist.

7. Verfahren nach einem der vorhergehenden Ansprüche, **dadurch gekennzeichnet, dass** die reaktive Gruppe F1 des Moleküls F aus einer Sylilgruppe und einer Pi-Konjugationsgruppe ausgewählt ist.

8. Verfahren nach einem der Ansprüche 5 und 7, **dadurch gekennzeichnet, dass** das Molekül F unter Trimethylsilylpropanethiol und Trimethoxysyslilpropanethiol ausgewählt ist.

9. Verfahren zur Herstellung eines Transistors, **dadurch gekennzeichnet, dass** es zumindest einen Schritt umfasst, in dem das Verfahren zur Verbesserung der Haftung einer Schicht aus einem Material M, vernetzbar durch Bestrahlung mit UV-Strahlen, auf einem Substrat nach einem der Ansprüche 1 bis 8 eingesetzt wird.

## Claims

1. Method for enhancing the adhesion of a layer made of a material M on the surface of a substrate S **characterised in that**:
- the material M is a cross-linkable material by insolation with UV rays,
and **in that** it comprises the following steps:
a) depositing on at least one surface of the substrate S a non-polymerised polymerisable composition P comprising at least one molecule F comprising a first reactive group F1 suitable for reacting, by insolation with UV rays, with a reactive group M1 of the surface of the material M, and a second reactive group F2 suitable for forming bonds with the constituent material(s) of the surface of the substrate S,
b) depositing, on the layer of the non-polymerised composition P, obtained in step a), a layer made of a non-cross-linked material M, and
c) insolating with UV rays the three-layer structure obtained in step b).

2. Method according to claim 1 **characterised in that** the surfaces of the substrate S comprises at least one area made of material(s) chosen from polyethylene terephthalate (PET), polyethylene naphthalate (PEN), a metal, a mineral or organic semiconductor material, and mixtures thereof.

3. Method according to claim 1 or 2 **characterised in that** the surface of the substrate comprises areas made of a metal chosen from Al, Au, Cu, Ag and mixtures thereof.

4. Method according to anyone of the preceding claims **characterised in that** the surface of the substrate S comprises areas made of aluminium and **in that** the reactive group F2 of the molecule F is a phosphonic acid group.

5. Method according to anyone of claims 1 to 3 **characterised in that** the surface of the substrate S comprises areas made of gold and **in that** the reactive group F2 of the molecule F is a thiol group.

6. Method according to anyone of the preceding claims **characterised in that** the material M is chosen in the group of materials based on acrylate, urethane acrylate, styrene and/or divinyl ether.

7. Method according to anyone of the preceding claims **characterised in that** the reactive group F1 of the molecule F is chosen from a silylated group and a pi-conjugated group.

8. Method according to claims 5 and 7 **characterised in that** the molecule F is chosen from trimethylsilylpropanethiol and trimethoxysilylpropanethiol.

9. Method for manufacturing a transistor **characterised in that** it comprises at least one step of carrying out the method for enhancing the adhesion of layer of material M cross-linkable by insolation with UV rays on a substrate according to anyone of claims 1 to 8.
